(19) Europäisches Patentamt
European Patent Office
Office européen des brevets

(11) Veröffentlichungsnummer: **0 041 678**
**B1**

(12) # EUROPÄISCHE PATENTSCHRIFT

(45) Veröffentlichungstag der Patentschrift: **10.04.85**

(21) Anmeldenummer: **81104179.7**

(22) Anmeldetag: **01.06.81**

(51) Int. Cl.⁴: **G 03 F 7/26,** G 03 F 7/10, G 03 C 1/70, C 08 G 73/06, C 08 L 79/04, C 08 L 79/08, H 01 B 3/30

(54) **Verfahren zur Herstellung hochwärmebeständiger Reliefstrukturen und deren Verwendung.**

(30) Priorität: **10.06.80 DE 3021787**

(43) Veröffentlichungstag der Anmeldung: **16.12.81 Patentblatt 81/50**

(45) Bekanntmachung des Hinweises auf die Patenterteilung: **10.04.85 Patentblatt 85/15**

(84) Benannte Vertragsstaaten: **AT BE CH DE FR GB IT LI NL SE**

(56) Entgegenhaltungen:
**EP-A-0 024 592**
**EP-A-0 026 299**
**EP-A-0 026 820**
**EP-A-0 026 821**

(73) Patentinhaber: **Siemens Aktiengesellschaft, Berlin und München Wittelsbacherplatz 2, D-8000 München 2 (DE)**

(72) Erfinder: **Ahne, Helmut, Dr., Heidestrasse 6, D-8551 Röttenbach (DE)**
Erfinder: **Kühn, Eberhard, Bergstrasse 32, D-8551 Hemhofen (DE)**
Erfinder: **Rubner, Roland, Dr., Buchenring 15, D-8551 Röttenbach (DE)**

EP 0 041 678 B1

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

ACTORUM AG

## Beschreibung

Die Erfindung betrifft ein Verfahren zur Herstellung hochwärmebeständiger Reliefstrukturen auf der Basis von Polymeren mit heterocyclischer Struktur durch Auftragen strahlungsempfindlicher löslicher Polymer-Vorstufen in Form einer Schicht oder Folie auf ein Substrat, Bestrahlen der Schicht bzw. Folie durch Negativvorlagen mit aktinischem Licht oder durch Führen eines Licht-, Elektronen- oder Ionenstrahls, Entfernen der nichtbestrahlten Schicht- bzw. Folienteile und gegebenenfalls durch nachfolgendes Tempern, sowie die Verwendung derart hergestellter Reliefstrukturen.

Aus der DE-B-2 308 830 ist ein Verfahren zur Herstellung von Reliefstrukturen der genannten Art bekannt. Bei diesem Verfahren werden als lösliche Polymer-Vorstufen Polyadditions- oder Polykondensationsprodukte polyfunktioneller carbocyclischer oder heterocyclischer, strahlungsempfindliche Reste tragender Verbindungen mit Diaminen, Diisocyanaten, Bis-säurechloriden oder Dicarbonsäuren verwendet. Die Verbindungen, die strahlungsempfindliche Reste tragen, enthalten dabei zwei für Additions- oder Kondensationsreaktionen geeignete Carboxyl-, Carbonsäurechlorid-, Amino-, Isocyanat- oder Hydroxylgruppen und teilweise in ortho- oder peri-Stellung dazu esterartig an Carboxylgruppen gebundene strahlungsreaktive Gruppen. Die mit diesen Verbindungen umzusetzenden Diamine, Diisocyanate, Bis-säurechloride und Dicarbonsäuren weisen mindestens ein cyclisches Strukturelement auf.

Die löslichen Polymer-Vorstufen werden beim Bestrahlen vernetzt und gehen dabei in unlösliche Zwischenprodukte über. Diese Zwischenprodukte unterliegen bei der Temperung einer Cyclisierung, wobei hochwärmebeständige Polymere folgender Stoffklassen gebildet werden: Polyimide (einschliesslich Polyamidimide und Polyesterimide), Poly-1.3-chinazolin-2.6-dione, Polyisoindolochinazolindione, Poly-1.3-oxazin-6-one und Polybenz-1.3-oxazin-2.4-dione.

Die nach dem bekannten Verfahren hergestellten Reliefstrukturen haben sich in der Praxis gut bewährt. Es hat sich aber auch gezeigt, dass noch Schwierigkeiten auftreten, die auf die Polymer-Vorstufen zurückzuführen sind. Diese sind nämlich nur in organischen Lösungsmitteln löslich, so dass einerseits die Verarbeitung nur in derartigen Lösungsmitteln erfolgen kann, und andererseits können die aus den Polymer-Vorstufen durch Bestrahlung hergestellten Strukturen auch nur mit Hilfe organischer Lösungsmittel entwickelt werden. Bei der Verwendung organischer Entwickler zur Entfernung der nichtbestrahlten Anteile treten aber insbesondere Probleme hinsichtlich der Toxizität und der Brennbarkeit sowie Probleme bei der Entsorgung auf.

Aufgabe der Erfindung ist es, das Verfahren der eingangs genannten Art zur Herstellung von Reliefstrukturen aus Polymer-Vorstufen weiter zu verbessern, wobei insbesondere die mit der Verwendung organischer Entwickler verbundenen Probleme entfallen sollen.

Dies wird erfindungsgemäss dadurch erreicht, dass als Polymer-Vorstufen Additionsprodukte von cyclischen Carbonsäureanhydriden mit hydroxylgruppenhaltigen Verbindungen verwendet werden, wobei die hydroxylgruppenhaltigen Verbindungen Additionsprodukte von olefinisch ungesättigten Monoepoxiden

– an carboxylgruppenhaltige Polyadditionsprodukte aus aromatischen und/oder heterocyclischen Tetracarbonsäuredianhydriden und Diaminoverbindungen oder Diaminoverbindungen mit wenigstens einer ortho-ständigen Amidogruppe bzw. an carboxylgruppenhaltige Polyadditionsprodukte aus aromatischen und/oder heterocyclischen Dihydroxydicarbonsäuren oder entsprechenden Diaminodicarbonsäuren und Diisocyanaten oder

– an aminogruppenhaltige Polykondensationsprodukte von aromatischen und/oder heterocyclischen Tetraaminoverbindungen mit Dicarbonsäurechloriden oder -estern bzw. an aminogruppenhaltige Polyadditionsprodukte aus den Tetraaminoverbindungen und Tetracarbonsäuredianhydriden oder

– an hydroxylgruppenhaltige Polykondensationsprodukte von aromatischen und/oder heterocyclischen Dihydroxydiaminoverbindungen mit Dicarbonsäurechloriden oder -estern sind.

Nach dem erfindungsgemässen Verfahren können Reliefstrukturen in vereinfachter Weise hergestellt werden, weil die dabei verwendeten Polymer-Vorstufen in wässrig-alkalischen Lösungsmitteln gut löslich sind. Somit wird es ermöglicht, dass bei der Herstellung von Polymeren auf der Basis von Negativresists die Entwicklung wie bei Positivresists vorgenommen werden kann, d.h. unter dem Einsatz von wässrig-alkalischen Entwicklern. Hierbei ergeben sich nicht nur wirtschaftliche Vorteile, weil Positivresistentwickler und -anlagen verwendet werden können, sondern es entfallen auch die mit der Verwendung organischer Entwickler verbundenen Gefahren, wie Toxizität und Brennbarkeit, sowie die Probleme hinsichtlich der Entsorgung, so dass sich auch gesundheitliche und ökologische Vorteile ergeben.

Beim erfindungsgemässen Verfahren können die Polymer-Vorstufen vorteilhaft zusammen mit licht- oder strahlungsempfindlichen copolymerisationsfähigen Verbindungen eingesetzt werden. Dazu werden vorzugsweise N-substituierte Maleinimide verwendet. Es können aber auch acrylat- bzw. methacrylatgruppenhaltige Verbindungen eingesetzt werden. Weiter können auch übliche Photoinitiatoren und/oder -sensibilisatoren verwendet werden (vgl.: «Industrie Chimique Belge», 24, 1959, Seiten 739 bis 764, sowie J. Kosar, «Light-Sensitive Systems», John Wiley Sons Inc., New York 1965, Seiten 143 bis 146 und Seiten 160 bis 180). Besonders geeignet sind Michlers Keton und/oder Benzoinäther, 2-tert.Butyl-9.10-anthrachinon, 1.2-Benz-9.10-anthrachinon und 4.4'-Bis-(diäthylamino)-benzophenon. Ferner können beim erfindungsgemässen Verfahren vorteilhaft Haftvermittler verwendet werden. Dazu dienen insbesondere Silane, wie Vinyltriäthoxysilan, Vi-

nyl-tris(β-methoxy-äthoxy)-silan, γ-Methacryloxy-propyl-trimethoxysilan und γ-Glycidoxy-propyl-trimethoxysilan.

Die beim erfindungsgemässen Verfahren eingesetzten strahlungsreaktiven Vorstufen, die oligomerer und/oder polymerer Natur sind, sind in der gleichzeitig eingereichten europäischen Patentanmeldung «Strahlungsreaktive Vorstufen hochwärmebeständiger Polymerer und deren Verwendung», Nr. 81 104 178.9 (EP-A-0 041 677), beschrieben. Diese Vorstufen weisen im allgemeinen folgende Struktur auf:

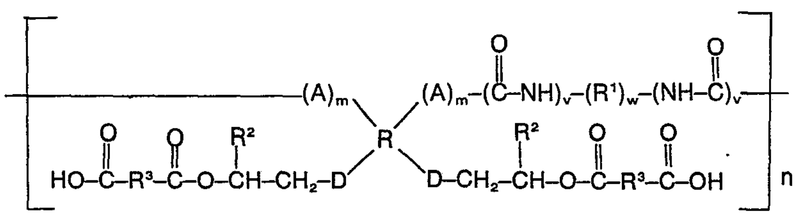
(1)

bzw.

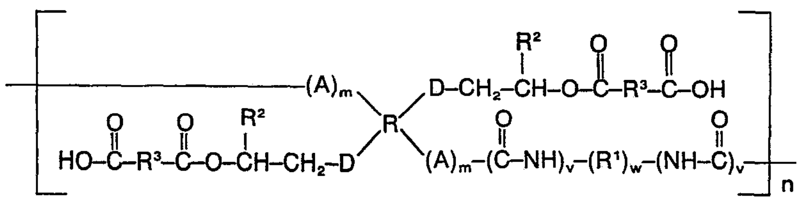
(2)

In den Formeln (1) und (2) bedeutet n eine ganze Zahl von 2 bis etwa 100; m, v und w sind 0 oder 1.

Für R, $R^1$, $R^2$, $R^3$, A und D gilt folgendes:

R ist ein – gegebenenfalls halogenierter – zumindest partiell aromatischer und/oder heterocyclischer tetravalenter, d.h. tetrafunktioneller Rest, bei dem jeweils zwei Valenzen in Nachbarstellung zueinander angeordnet sind; weist der Rest R mehrere aromatische und/oder heterocyclische Strukturelemente auf, so befinden sich die Valenzpaare jeweils an entständigen derartigen Strukturelementen;

$R^1$ ist ein – gegebenenfalls halogenierter – divalenter, d.h. difunktioneller Rest aliphatischer und/oder cycloaliphatischer, gegebenenfalls Heteroatome aufweisender, und/oder aromatischer und/oder heterocyclischer Struktur;

$R^2$ ist ein olefinisch ungesättigter Rest, beispielsweise eine allylätherhaltige oder eine maleinimidhaltige Gruppe, und insbesondere eine – gegebenenfalls substituierte – (meth)acrylesterhaltige Gruppe;

$R^3$ ist ein – gegebenenfalls halogenierter – divalenter, d.h. difunktioneller Rest aliphatischer und/oder cycloaliphatischer, olefinisch ungesättigter und/oder aromatischer und/oder heterocyclischer Struktur;

O
||
A bedeutet –O–, –NH– oder –NH–C– und
D bedeutet –C–O–, –O–, –S–, –NH– oder
||
O

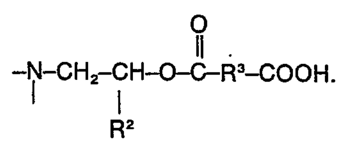

Dabei gilt folgendes:

Bei m = 1 und v = 1 ist A = –NH– oder –O– und
D = –C–O–;
||
O
bei m = O und v = 1 ist D = –C–O–;
||
O
bei m = 1 und v = O ist A = –NH–C– und D =
–O–, –S–, –NH–
||
O

oder 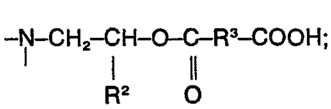

bei m = O und w = O ist v = 1.

Bevorzugt sind dabei folgende, in den nachfolgenden Formeln (3) bis (9) dargestellte Polymer-Vorstufen.

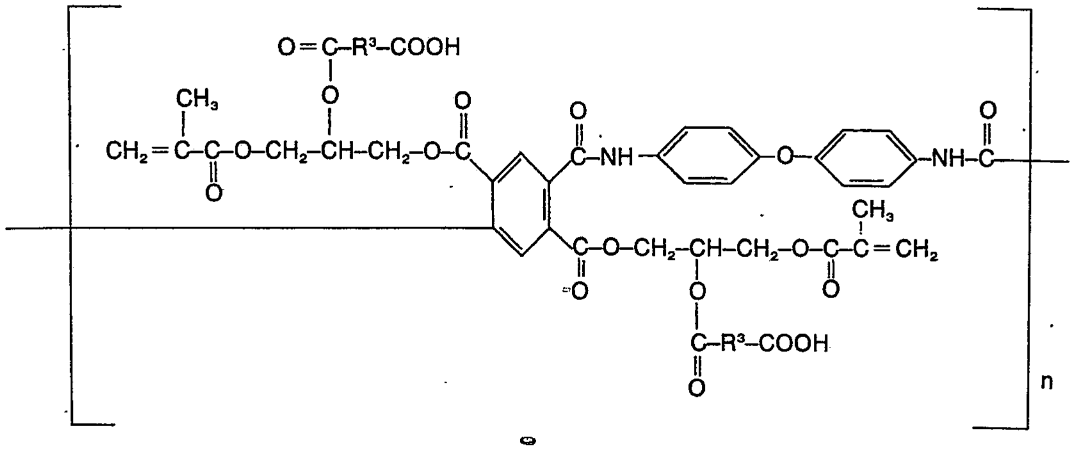

(3)

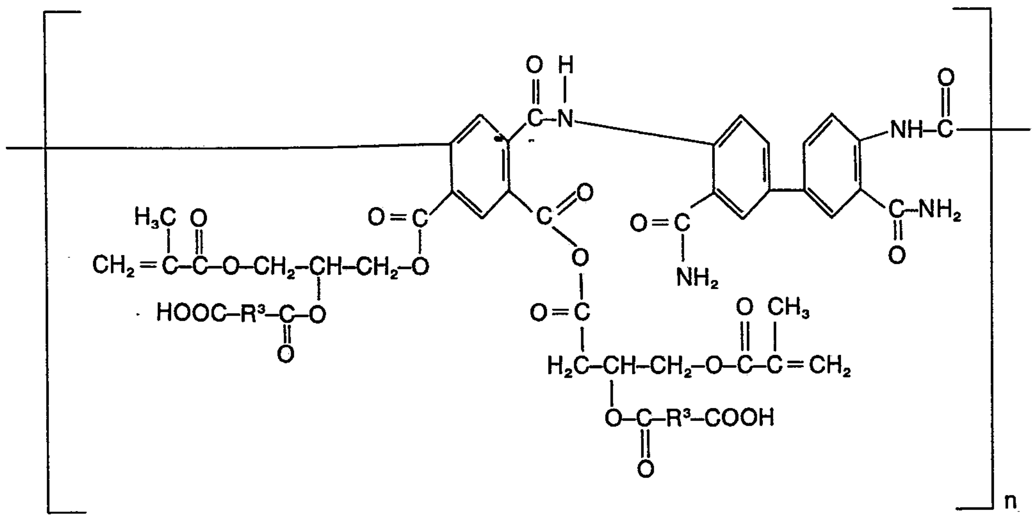

(4)

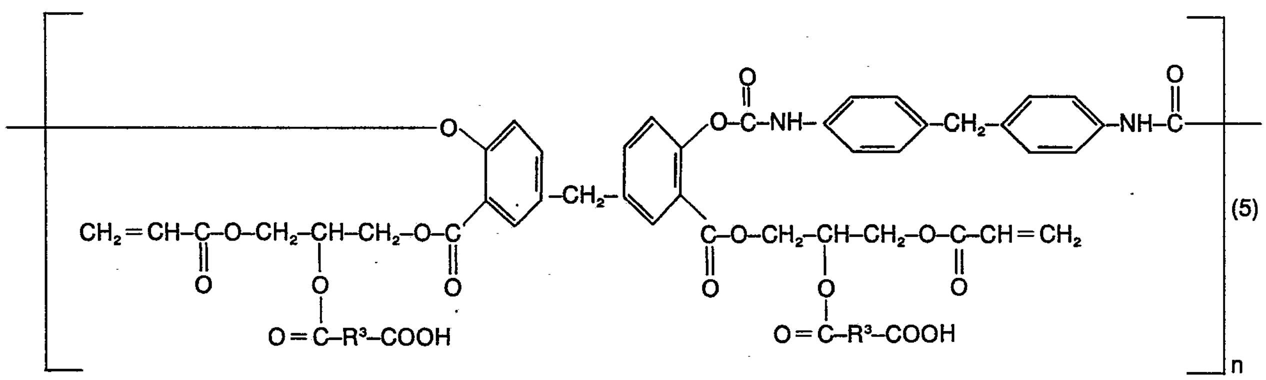

(5)

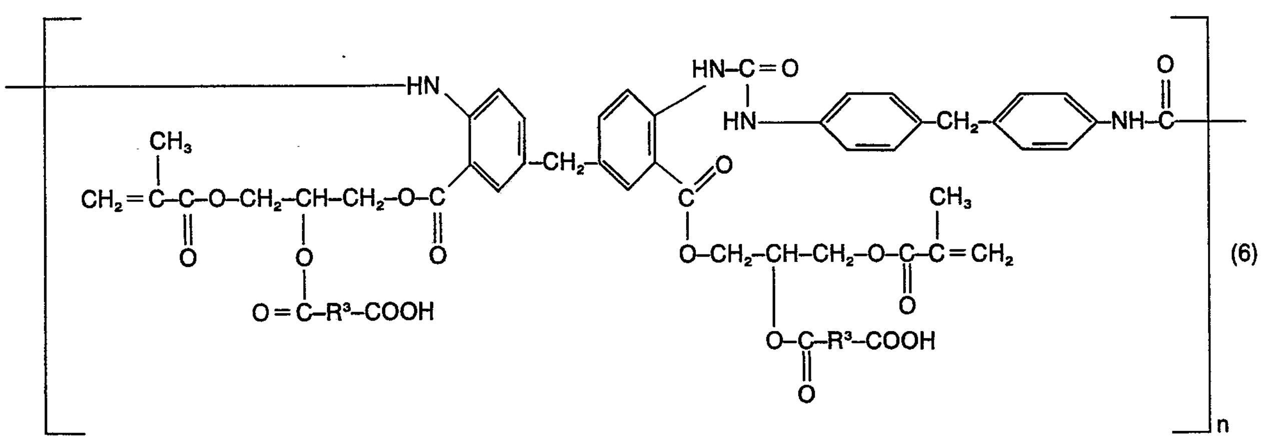

(6)

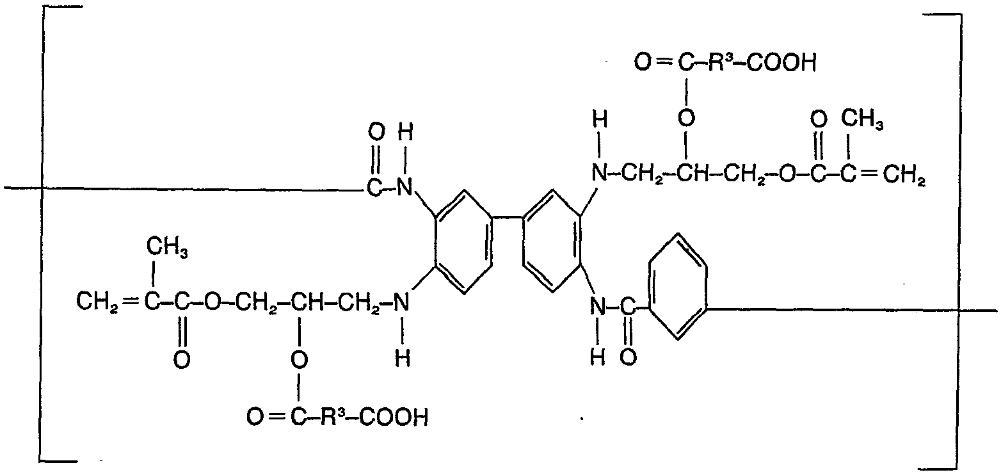

(7)

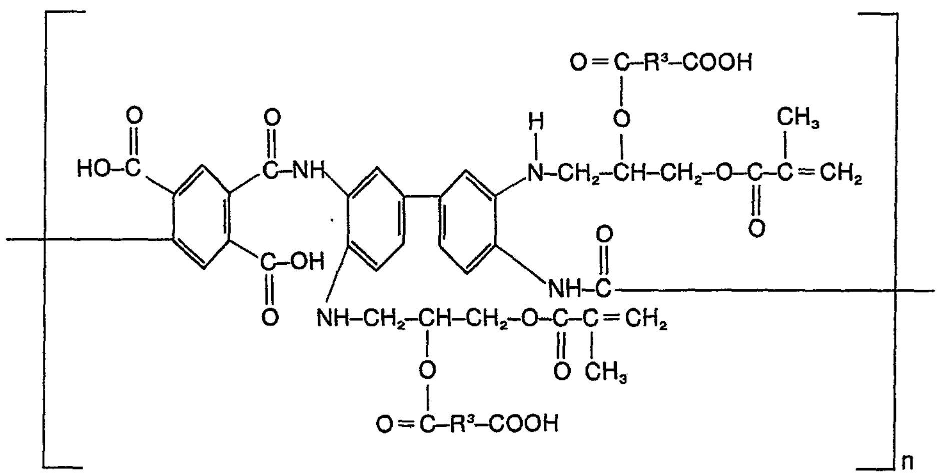

(8)

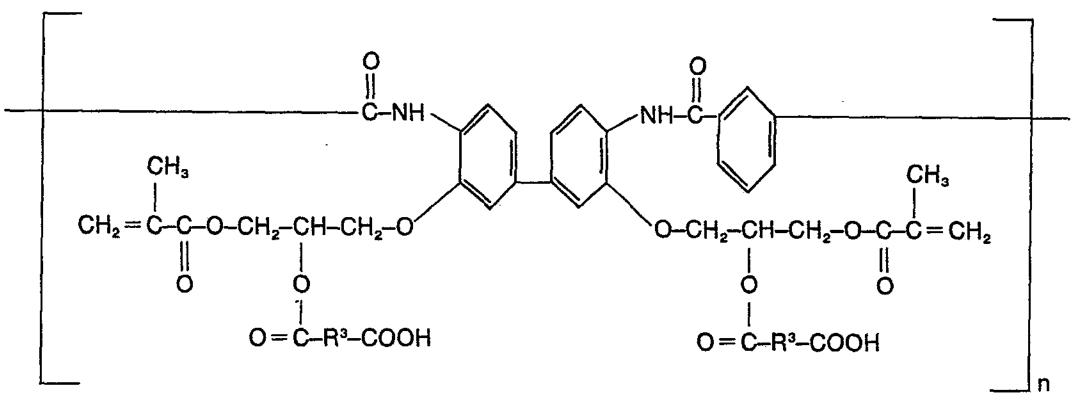

(9)

(3) Additionsprodukt aus einem Carbonsäureanhydrid und einer Polyimid-Vorstufe, erhalten durch Addition von Glycidylmethacrylat an das Polyadditionsprodukt aus Pyromellithsäuredianhydrid und 4.4′-Diaminodiphenyläther;

(4) Additionsprodukt aus einem Carbonsäureanhydrid und einer Polyisoindolochinazolindion-Vorstufe, erhalten durch Addition von Glycidylmethacrylat an das Polyadditionsprodukt aus Pyromellithsäuredianhydrid und 4.4′-Diaminodiphenyl-3.3′-dicarbonsäureamid;

(5) Additionsprodukt aus einem Carbonsäureanhydrid und einer Polyoxazindion-Vorstufe, und zwar speziell einer Polybenzoxazindion-Vorstufe, erhalten durch Addition von Glycidylacrylat an das Polyadditionsprodukt aus 4.4′-Dihydroxydiphenylmethan-3.3′-dicarbonsäure und 4.4′-Diphenylmethandiisocyanat;

(6) Additionsprodukt aus einem Carbonsäureanhydrid und einer Polychinazolindion-Vorstufe, erhalten durch Addition von Glycidylmethacrylat an das Polyadditionsprodukt aus 4.4′-Diaminodiphenylmethan-3.3′-dicarbonsäure und 4.4′-Diphenylmethandiisocyanat;

(7) Additionsprodukt aus einem Carbonsäureanhydrid und einer Polyimidazol-Vorstufe, und

zwar speziell einer Polybenzimidazol-Vorstufe, erhalten durch Addition von Glycidylmethacrylat an das Polykondensationsprodukt aus 3.3′-Diaminobenzidin und Isophthalsäuredimethylester;

(8) Additionsprodukt aus einem Carbonsäureanhydrid und einer Polyimidazopyrrolon-Vorstufe, erhalten durch Addition von Glycidylmethacrylat an das Polyadditionsprodukt aus 3.3′-Diaminobenzidin und Pyromellithsäuredianhydrid;

(9) Additionsprodukt aus einem Carbonsäureanhydrid und einer Polyoxazol-Vorstufe, und zwar speziell einer Polybenzoxazol-Vorstufe, erhalten durch Addition von Glycidylmethacrylat an das Polykondensationsprodukt aus 3.3′-Dihydroxybenzidin und Isophthalsäuredichlorid.

Die Herstellung der erfindungsgemässen Reliefstrukturen erfolgt, wie bereits erwähnt, in der Weise, dass die Polymer-Vorstufe in Form einer Schicht oder Folie auf ein Substrat aufgebracht und mit aktinischem Licht durch eine Maske belichtet oder durch Führen eines Licht-, Elektronen- oder Ionenstrahls bestrahlt wird; anschliessend werden die nichtbelichteten bzw. nichtbestrahlten Schicht- oder Folienteile herausgelöst oder abgezogen und die dabei erhaltenen Reliefstrukturen werden gegebenenfalls getempert.

Die Vorstufe kann in einem organischen Lösungsmittel, insbesondere N-Methylpyrrolidon, gelöst auf das Substrat aufgebracht werden, als Lösungsmittel können aber auch wässrig-alkalische Lösungen dienen. Die Konzentration der Entwicklerlösung kann so eingestellt werden, dass mit bekannten Beschichtungsverfahren, wie Schleudern, Tauchen, Sprühen, Bürsten oder Rollen, Schichtstärken von 0,01 µm bis einige 100 µm erzeugt werden können. Es hat sich gezeigt, dass beispielsweise beim Schleuderbeschichten 300 vis 10 000 Umdrehungen/min für die Dauer von 1 bis 100 s geeignet sind, um eine gleichmässige und gute Oberflächenqualität zu erzielen.

Die auf das Substrat, das vorzugsweise aus Siliciumdioxid oder Siliciumnitrid, Glas, Metall, Kunststoff oder halbleitendem Material besteht, aufgebrachte Photoresistschicht kann bei Raumtemperatur oder bei erhöhter Temperatur, vorzugsweise bei einer Temperatur von 50 bis 80 °C, in einem Stickstoff- oder Luftstrom vom Lösungsmittel befreit werden; dabei kann auch im Vakuum gearbeitet werden.

Zur Erzielung eines ausreichenden Löslichkeitsunterschiedes zwischen den bestrahlten und den nichtbestrahlten Schicht- bzw. Folienteilen genügen beim erfindungsgemässen Verfahren – bei der Verwendung einer 500 W-Quecksilberhöchstdrucklampe – in Abhängigkeit von der Zusammensetzung und der Schichtstärke Belichtungszeiten zwischen 10 und 800 s. Nach dem Belichten werden die nichtbelichteten Teile der Schicht bzw. Folie mit einem wässrig-alkalischen Entwickler herausgelöst.

Mittels des erfindungsgemässen Verfahrens werden konturenscharfe Bilder, d. h. Reliefstrukturen, erhalten, die durch Temperung in hochwärmebeständige, gegenüber Säuren und Laugen resistente Polymere umgewandelt werden. Im allgemeinen können Temperaturen von 150 bis 500 °C gewählt werden, vorzugsweise wird bei Temperaturen von 300 bis 400 °C getempert. Die Temperzeit beträgt im allgemeinen 10 Minuten bis eine Stunde, vorzugsweise eine halbe Stunde, wobei unter Inertgas im allgemeinen keine wesentliche Verfärbung zu beobachten ist. Die Kantenschärfe und die Massgenauigkeit der Reliefstrukturen werden durch die Temperung praktisch nicht beeinträchtigt. Darüber hinaus bleibt die gute Oberflächenqualität der Reliefstrukturen trotz eines beim Tempern eintretenden Schichtstärkenverlustes erhalten.

Die erfindungsgemässen Reliefstrukturen können zur Herstellung von Passivierungsschichten auf Halbleiterbauelementen, von Dünn- und Dickfilmschaltungen, von Lötschutzschichten auf Mehrlagenschaltungen, von Isolierschichten als Bestandteil von Schichtschaltungen und von miniaturisierten Isolierschichten auf elektrisch leitenden und/oder halbleitenden und/oder isolierenden Basismaterialien, insbesondere im Bereich der Mikroelektronik oder allgemein für die Feinstrukturierung von Substraten, Anwendung finden. Vorzugsweise dienen die hochwärmebeständigen Reliefstrukturen als Masken für Nass- und Trockenätzprozesse, stromlose oder galvanische Metallabscheidung und Aufdampfverfahren sowie als Masken für die Ionenimplantation, darüber hinaus als Isolier- und Schutzschichten in der Elektrotechnik. Ferner können die Reliefstrukturen vorteilhaft als Orientierungsschichten, beispielsweise in Flüssigkristalldisplays, sowie zur Rasterung von Oberflächen, beispielsweise bei Röntgenschirmen, insbesondere Röntgenbildverstärkern, verwendet werden. Sie eignen sich darüber hinaus als Dielektrikum für kapazitive Feuchtesensoren und als lichtleitende Schichten in der Optoelektronik sowie zur Herstellung von Druckplatten.

Anhand von Ausführungsbeispielen soll die Erfindung noch näher erläutert werden.

Beispiel 1

Herstellung einer strahlungsreaktiven Vorstufe für Polybenzoxazol

Zu einer Lösung von 6,49 Gewichtsteilen 3.3′-Dihydroxybenzidin in 50 Volumenteilen Dimethylacetamid und 9 Volumenteilen Pyridin werden unter intensivem Rühren bei einer Temperatur von −5 bis −20 °C innerhalb von etwa 30 min 6,1 Gewichtsteile Isophthalsäuredichlorid in 20 Volumenteilen Cyclohexanon getropft. Nach 3stündigem weiterem Rühren bei Raumtemperatur wird die viskose Reaktionslösung über Nacht stehengelassen, dann wird die Lösung unter Rühren in 1000 Volumenteile Wasser getropft. Das sich dabei abscheidende Harz wird abgetrennt, mit Wasser und Methanol gewaschen und im Vakuum bei ca. 60 °C getrocknet.

10 Gewichtsteile des auf die beschriebene Weise hergestellten Polybenzoxazol-Prepolymeren werden in 100 Volumenteilen N-Methylpyrrolidon gelöst. Zu dieser Lösung werden 50 Volumenteile

Glycidylmethacrylat, 0,5 Volumenteile Benzyldimethylamin und 0,5 Gewichtsteile Hydrochinon gegeben. Nach 2stündigem Erwärmen auf eine Temperatur von ca. 90 °C wird das Reaktionsprodukt unter Rühren aus 1000 Volumenteilen Äthanol gefällt und im Vakuum getrocknet.

3,2 Gewichtsteile des erhaltenen Additionsproduktes werden in 35 Volumenteilen N-Methylpyrrolidon gelöst. Unter Rühren wird zu dieser Lösung 1 Gewichtsteil Itaconsäureanhydrid gegeben. Nach einer Reaktionsdauer von 20 h bei Raumtemperatur wird für 3 h auf 50 bis 60 °C erwärmt. Danach wird die Reaktionslösung unter kräftigem Rühren in 500 Volumenteile Wasser getropft. Der anfallende Niederschlag wird abgesaugt und im Vakuum bei Raumtemperatur getrocknet.

Herstellung der Reliefstruktur

2 Gewichtsteile des auf die vorstehend beschriebene Weise hergestellten Harzes werden zusammen mit 0,1 Gewichtsteilen N-Phenylmaleinimid und 0,04 Gewichtsteilen Michlers Keton in 10 Volumenteilen eines Dimethylacetamid/Dioxan-Gemisches (Volumenverhältnis 1:1) gelöst und bei 2000 Umdrehungen/min auf eine Aluminiumfolie geschleudert. Nach 2stündigem Trocknen im Vakuum bei 60 °C wird mit einer 500 W-Quecksilberhöchstdrucklampe durch eine Kontaktmaske belichtet und danach 2 min lang mit 0,7%iger Natronlauge entwickelt. Dabei werden Schichten mit einer Schichtdicke von 4,6 µm erhalten, wobei noch Strukturen von 10 µm aufgelöst werden. Nach dem Tempern bei 400 °C für 45 min beträgt die Schichtdicke 2,6 µm. Die Kantenschärfe und die Auflösung der Reliefstrukturen werden durch das Tempern nicht beeinträchtigt.

Beispiel 2

Herstellung einer strahlungsreaktiven Vorstufe für Polybenzimidazol

10,7 Gewichtsteile 3.3′-Diaminobenzidin werden in 95 Volumenteilen N-Methylpyrrolidon gelöst und zusammen mit 9,7 Gewichtsteilen Isophthalsäuredimethylester für 8 h auf eine Temperatur von 150 bis 175 °C und anschliessend 2 Tage auf ca. 185 °C erhitzt. Diese Lösung wird dann mit 40 Volumenteilen Glycidylmethacrylat versetzt. Nach einer Reaktionsdauer von 48 h bei Raumtemperatur und 4 h bei etwa 50 bis 60 °C werden zu der Reaktionsmischung 8 Gewichtsteile Itaconsäureanhydrid gegeben und innerhalb von 4 Tagen bei Raumtemperatur umgesetzt.

Herstellung der Reliefstruktur

Der auf die vorstehend beschriebene Weise hergestellten Reaktionslösung werden 0,9 Gewichtsteile N-Phenylmaleinimid und 0,55 Gewichtsteile Michlers Keton zugesetzt und dieses Gemisch wird bei 1000 Umdrehungen/min auf eine Aluminiumfolie geschleudert. Nach einem Trokkenprozess bei 50 bis 60 °C im Vakuum für die Dauer von 2 h beträgt die Schichtdicke 4,6 µm. Anschliessend wird 5 min lang mit einer 500 W-Quecksilberhöchstdrucklampe durch eine Kontaktmaske belichtet und dann 15 s lang mit einem handelsüblichen alkalischen Entwickler, der im Volumenverhältnis 1:3 mit Wasser verdünnt worden ist, tauchentwickelt. Dabei werden 50 µm-Strukturen der Maske kantenscharf abgebildet. Ein 30minütiger Tempervorgang bei 300 °C führt zu einer Schichtdicke von 2,4 µm, wobei die gute Bildqualität nicht beeinträchtigt wird.

Beispiel 3

Herstellung einer strahlungsreaktiven Vorstufe für Polyimid

Zu 65,4 Gewichtsteilen Pyromellithsäuredianhydrid (0,3 Mol) in 450 Volumenteilen Dimethylacetamid werden unter Rühren 45 Gewichtsteile 4.4′-Diaminodiphenyläther (0,23 Mol) gegeben und anschliessend wird 2 h bei Raumtemperatur gerührt. Dann werden dem Reaktionsgemisch 2 Gewichtsteile Methacrylsäure-2-hydroxyäthylester (0,016 Mol) zugesetzt, um die noch vorhandenen endständigen Anhydridgruppen zu binden. Nach 2stündigem Rühren bei Raumtemperatur werden zur Reaktionslösung 150 Volumenteile Glycidylmethacrylat, 1,5 Volumenteile Benzyldimethylamin und 0,1 Gewichtsteile Hydrochinon gegeben. Anschliessend wird die Lösung unter Rühren 23 h auf eine Temperatur von 50 bis 60 °C erwärmt und dann wird sie unter kräftigem Rühren zu 4000 Volumenteilen Äthanol getropft. Der dabei gebildete Niederschlag wird abgesaugt und im Vakuum bei Raumtemperatur getrocknet. 35 Gewichtsteile der erhaltenen Polyimid-Vorstufe werden in 100 Volumenteilen Dimethylacetamid gelöst und dazu 10 Gewichtsteile Maleinsäureanhydrid gegeben. Nach einer Reaktionsdauer von 5 Tagen bei Raumtemperatur wird die Harzlösung mit 50 Volumenteilen Dimethylacetamid verdünnt und aus 2500 Volumenteilen Wasser gefällt. Das Harz wird mit Wasser gewaschen und im Vakuum getrocknet.

Herstellung der Reliefstruktur

4,5 Gewichtsteile des auf die vorstehend beschriebene Weise hergestellten Harzes werden zusammen mit 0,2 Gewichtsteilen N-Phenylmaleinimid und 0,09 Gewichtsteilen Michlers Keton in 10 Volumenteilen Dimethylacetamid gelöst. Nachfolgend wird bei 6000 Umdrehungen/min auf eine Aluminiumfolie aufgeschleudert und für 1 h im Vakuum bei 60 °C getrocknet. Die Dicke der dabei erhaltenen Schicht beträgt 1,6 µm. Diese Schicht wird 10 min lang mit UV-Licht (500 W-Quecksilberhöchstdrucklampe) durch eine Maskenvorlage bestrahlt und 15 s lang mit einem mit Wasser verdünnten handelsüblichen alkalischen Entwickler und dann noch 10 s lang mit Wasser besprüht. Dabei entstehen kantenscharfe Strukturen mit einer Auflösung von 50 µm. Nachdem die Schicht 30 min auf 300 °C und 20 min auf 400 °C erhitzt wurde, betrug die Schichtdicke 0,85 µm, die Kantenschärfe blieb unverändert.

Beispiel 4

Herstellung einer strahlungsreaktiven Vorstufe für Polyisoindolochinazolindion

11 Gewichtsteile 4.4′-Diaminodiphenyl-3.3′-dicarbonsäureamid werden in 120 Volumenteilen Dimethylacetamid aufgeschlämmt und unter Rühren mit 10 Gewichtsteilen Pyromellithsäuredianhydrid, gelöst in 100 Volumenteilen eines Dimethylacetamid/Dimethylformamid-Gemisches (Volumenverhältnis 1:1), versetzt. Nach 2stündigem Rühren werden zur erhaltenen Lösung 25 Volumenteile Glycidylmethacrylat, 0,5 Volumenteile Benzyldimethylamin und 0,05 Gewichtsteile Hydrochinonmonomethyläther gegeben. Nach 25stündigem Rühren bei einer Temperatur von 60 °C wird aus der Lösung mit 3000 Volumenteilen Propanol ein Harz ausgefällt und getrocknet.

10 Gewichtsteile des Harzes werden in 100 Volumenteilen Dimethylacetamid gelöst und mit 5 Gewichtsteilen Maleinsäureanhydrid versetzt. Nach 5tägigem Stehen bei ca. 30 °C wird die Reaktionslösung in 1000 Volumenteile Wasser getropft und das ausfallende Harz getrocknet.

Herstellung der Reliefstruktur

3 Gewichtsteile des auf die vorstehend beschriebene Weise hergestellten Harzes werden zusammen mit 0,1 Gewichtsteilen N-Phenylmaleinimid und 0,06 Gewichtsteilen Michlers Keton in 20 Volumenteilen Dimethylformamid gelöst und auf einer Aluminiumfolie zu 1 µm starken Filmen geschleudert. Anschliessend wird bei 60 °C getrocknet und mit einer 500 W-Querksilberhöchstdrucklampe 7 min lang durch eine Kontaktmaske belichtet. Nach der Entwicklung mit einer wässrig-alkalischen Entwicklerlösung (Dauer: 15 s) werden Reliefstrukturen erhalten, deren Geometrie auch bei halbstündigem Tempern bei 400 °C nicht verändert wird; die Schichtdicke beträgt nach der thermischen Behandlung 0,7 µm.

**Patentansprüche**

1. Verfahren zur Herstellung hochwärmebeständiger Reliefstrukturen auf der Basis von Polymeren mit heterocyclischer Struktur durch Auftragen strahlungsempfindlicher löslicher Polymer-Vorstufen in Form einer Schicht oder Folie auf ein Substrat, Bestrahlen der Schicht bzw. Folie durch Negativvorlagen mit aktinischem Licht oder durch Führen eines Licht-, Elektronen- oder Ionenstrahls, Entfernen der nichtbestrahlten Schicht- bzw. Folienteile und gegebenenfalls durch nachfolgendes Tempern, dadurch gekennzeichnet, dass als Polymer-Vorstufen Additionsprodukte von cyclischen Carbonsäureanhydriden mit hydroxylgruppenhaltigen Verbindungen verwendet werden, wobei die hydroxylgruppenhaltigen Verbindungen Additionsprodukte von olefinisch ungesättigten Monoepoxiden

– an carboxylgruppenhaltige Polyadditionsprodukte aus aromatischen und/oder heterocyclischen Tetracarbonsäuredianhydriden und Diaminoverbindungen oder Diaminoverbindungen mit wenigstens einer ortho-ständigen Amidogruppe bzw. an carboxylgruppenhaltige Polyadditionsprodukte aus aromatischen und/oder heterocyclischen Dihydroxydicarbonsäuren oder entsprechenden Diaminodicarbonsäuren und Diisocyanaten oder

– an aminogruppenhaltige Polykondensationsprodukte von aromatischen und/oder heterocyclischen Tetraaminoverbindungen mit Dicarbonsäurechloriden oder -estern bzw. an aminogruppenhaltige Polyadditionsprodukte aus den Tetraaminoverbindungen und Tetracarbonsäuredianhydriden oder

– an hydroxylgruppenhaltige Polykondensationsprodukte von aromatischen und/oder heterocyclischen Dihydroxydiaminoverbindungen mit Dicarbonsäurechloriden oder -estern sind.

2. Verfahren nach Anspruch 1, dadurch gekennzeichnet, dass die Polymer-Vorstufen zusammen mit licht- oder strahlungsempfindlichen copolymerisationsfähigen Verbindungen, insbesondere N-substituierten Maleinimiden, eingesetzt werden.

3. Verfahren nach Anspruch 1 oder 2, dadurch gekennzeichnet, dass Haftvermittler, insbesondere Silane, verwendet werden.

4. Verfahren nach einem der Ansprüche 1 bis 3, dadurch gekennzeichnet, dass ein Additionsprodukt von Maleinsäureanhydrid an eine hydroxylgruppenhaltige Polyimid-Vorstufe verwendet wird.

5. Verfahren nach einem der Ansprüche 1 bis 3, dadurch gekennzeichnet, dass ein Additionsprodukt von Maleinsäureanhydrid an eine hydroxylgruppenhaltige Polyisoindolochinazolindion-Vorstufe verwendet wird.

6. Verfahren nach einem der Ansprüche 1 bis 3, dadurch gekennzeichnet, dass ein Additionsprodukt von Itaconsäureanhydrid an eine hydroxylgruppenhaltige Polyimidazol-Vorstufe verwendet wird.

7. Verfahren nach einem der Ansprüche 1 bis 3, dadurch gekennzeichnet, dass ein Additionsprodukt von Itaconsäureanhydrid an eine hydroxylgruppenhaltige Polyoxazol-Vorstufe verwendet wird.

8. Hochwärmebeständige Reliefstruktur, hergestellt nach einem oder mehreren der Ansprüche 1 bis 7.

9. Verwendung der Reliefstruktur nach Anspruch 8 als Resist mit intermediärer Schutzfunktion zur lithographischen Strukturierung von Oberflächen, insbesondere bei Trockenätzverfahren.

10. Verwendung der Reliefstruktur nach Anspruch 8 zur dauerhaften Beschichtung oder Rasterung von Oberflächen.

11. Verwendung der Reliefstruktur nach Anspruch 8 als Schutz- und Isolierstoff in der Elektrotechnik.

**Claims**

1. A process for the production of highly heat-resistant relief structures based on polymers with heterocyclic structure by applying radiation-sensitive, soluble polymer precursors in the form

of a layer or film to a substrate, irradiation of the layer or film through negative patterns by means of actinic light or by passage thereover of a light, an electron, or an ion beam, and removal of the non-irradiated parts of the layer or film, possibly followed by heat-treatment, characterised in that the polymer precursors are addition products of cyclic carboxylic acid anhydrides with compounds containing hydroxyl groups, where the compounds which contain hydroxyl groups are addition products of olefinically-unsaturated monoepoxides

– with carboxyl group-containing polyaddition products of aromatic and/or heterocyclic tetracarboxylic acid dianhydrides with diamino compounds or diamino compounds having at least one amido group in the ortho-position; or carboxyl group-containing polyaddition products of aromatic and/or heterocyclic dihydroxydicarboxylic acids or corresponding diaminodicarboxylic acids with diisocyanates; or

– with amino group-containing polycondensation products of aromatic and/or heterocyclic tetraamino compounds with dicarboxylic acid chlorides or esters; or amino group-containing polyaddition products of the tetraamino compounds with tetracarboxylic acid dianhydrides; or

– with hydroxyl group-containing polycondensation products of aromatic and/or heterocyclic dihydroxydiamino compounds with dicarboxylic acid chlorides or esters.

2. A process as claimed in Claim 1, characterised in that the polymer precursors are used together with light- or radiation-sensitive compounds which are capable of co-polymerisation, in particular N-substituted maleic imides.

3. A process as claimed in Claim 1 or Claim 2, characterised in that bonding agents, in particular silanes, are used.

4. A process as claimed in one of Claims 1 to 3, characterised in that an addition product of maleic acid anhydride with a polyimide precursor containing hydroxyl groups, is used.

5. A process as claimed in one of Claims 1 to 3, characterised in that an addition product of maleic acid anhydride with a polyisoindoloquinazolinedione precursor containing hydroxyl groups, is used.

6. A process as claimed in one of Claims 1 to 3, characterised in that an addidion product of itaconic acid anhydride with a polyimidazole precursor containing hydroxyl groups, is used.

7. A process as claimed in one of Claims 1 to 3, characterised in that an addition product of itaconic acid anhydride with a polyoxazole precursor containing hxydoxyl groups, is used.

8. A highly heat-resistant relief structure produced in accordance with one or more of Claims 1 to 7.

9. Use of the relief structure as claimed in Claim 8 as a resist having an intermediary protective function for the lithographic structuring of surfaces, in particular in dry etching processes.

10. Use of the relief structure as claimed in Claim 8 for the permanent coating or gridding of surfaces.

11. Use of the relief structure as claimed in Claim 8 as a protective and insulating material in electrical engineering.

**Revendications**

1. Procédé de fabrication de structures en relief très stables aux températures élevées, à base de polymères ayant une structure hétérocyclique, qui consiste à déposer des précurseurs de polymères solubles et sensibles au rayonnement, sous forme d'une couche ou d'une feuille sur un substrat, à exposer la couche ou la feuille à travers des négatifs d'originaux à de la lumière actinique, ou à envoyer un faisceau lumineux, un faisceau d'électrons ou un faisceau d'ions, à éliminer les parties de la couche ou de la feuille qui n'ont pas été exposées et, le cas échéant, à effectuer ensuite un recuit, caractérisé en ce qu'il consiste à utiliser comme précurseurs de polymères des produits d'addition d'anhydrides d'acide carboxylique cycliques et de composés hydroxylés, les composés hydroxylés étant des produits d'addition de monoépoxydes insaturés oléfiniquement

– sur des produits de polyaddition carboxylés constitués à partir de dianhydrides d'acides tétracarboxyliques aromatiques et/ou hétérocycliques et de composé diamino ou de composés diamino ayant au moins un groupe amido en position ortho ou sur des produits de polyaddition carboxylés constitués à partir d'acides dihydroxydicarboxyliques aromatiques et/ou hétérocycliques ou d'acides diaminodicarboxyliques correspondants et de diisocyanates ou

– sur des produits de polycondensation aminés de composés tétraamino aromatiques et/ou hétérocycliques et de chlorures d'acide dicarboxylique ou d'esters d'acide dicarboxylique ou sur des produits de polyaddition aminés constitués à partir de composés tétraamino et de dianhydrides d'acides tétracarboxyliques ou

– sur des produits de polycondensation hydroxylés de composés dihydroxydiamino aromatiques et/ou hétérocycliques et de chlorures d'acide dicarboxylique ou d'esters d'acide dicarboxylique.

2. Procédé suivant la revendication 1, caractérisé en ce qu'il consiste à utiliser les précurseurs de polymères en même temps que des composés sensibles à la lumière ou au rayonnement, susceptibles de subir une copolymérisation, notamment des maléinimides substitués sur l'azote.

3. Procédé suivant la revendication 1 ou 2, caractérisé en ce qu'il consiste à utiliser des agents de couplage, notamment des silanes.

4. Procédé suivant l'une des revendications 1 à 3, caractérisé en ce qu'il consiste à utiliser un produit d'addition de l'anhydride maléique sur un précurseur de polyimide hydroxylé.

5. Procédé suivant l'une des revendications 1 à 3, caractérisé en ce qu'il consiste à utiliser un produit d'addition de l'anhydride maléique sur un précurseur de polyisoindoloquinazolinedione hydroxylé.

6. Procédé suivant l'une des revendications 1 à 3, caractérisé en ce qu'il consiste à utiliser un produit d'addition de l'anhydride itaconique sur un précurseur de polyimidazole hydroxylé.

7. Procédé suivant l'une des revendications 1 à 3, caractérisé en ce qu'il consiste à utiliser un produit d'addition de l'anhydride itaconique sur un précurseur de polyoxazole hydroxylé.

8. Structure en relief très stable aux températures élevées fabriqué suivant l'une ou plusieurs des revendications 1 à 7.

9. Utilisation de la structure en relief suivant la revendication 8 comme résist ayant une fonction intermédiaire de protection pour la sutructuration lithographique de surfaces, notamment dans un procédé de gravure à sec.

10. Utilisation de la structure en relief suivant la revendication 8 pour le revêtement ou la réticulatoire permanent de surfaces.

11. Utilisation de la structure en relief suivant la revendication 8 comme substance de protection et isolante en électrotechnique.